# EUROPEAN PATENT SPECIFICATION

(11) **EP 4 535 605 B1**
(45) Date of publication and mention of the grant of the patent: **08.04.2026**
(21) Application number: 24164883.1
(22) Date of filing: 20.03.2024
(51) Int. Cl.: H02J 7/00, H01M 10/48

(54) **BATTERY PACK, METHOD OF MEASURING CHARGE CURRENT OF THE SAME, AND CHARGE CURRENT MEASUREMENT SYSTEM**
BATTERIEPACK, VERFAHREN ZUR MESSUNG DES LADESTROMS DAVON UND LADESTROMMESSSYSTEM
BLOC-BATTERIE, PROCÉDÉ DE MESURE DE COURANT DE CHARGE DE CELUI-CI ET SYSTÈME DE MESURE DE COURANT DE CHARGE

(30) Priority: 06.10.2023 KR 20230133095
(43) Date of publication of application: 09.04.2025
(73) Proprietor: Samsung SDI Co., Ltd., Yongin-si, Gyeonggi-do 17084 (KR)
(72) Inventor: SEO, Young Dong, 16678 Suwon-si (KR)
(74) Representative: Marks & Clerk LLP

(56) References cited:
- JP-A- 2018 033 257
- JP-B2- 4 344 715

## Description

### BACKGROUND

### 1. Field

The present disclosure relates to a battery pack enabling measurement of a sinusoidal waveform charge current, a method of measuring a charge current of the same, and a charge current measurement system.

### 2. Description of the Related Art

Typically, light electric vehicles (LEVs) including golf carts or energy storage systems (ESSs) employ constant current (CC)-constant voltage (CV) charging and some chargers supply a charge current in a sinusoidal current pattern. In this case, the frequency of sinusoidal waves is twice an input frequency of charger AC.

Upon charging a battery pack using a charger that supplies a charge current in a sinusoidal current pattern, a battery management system (BMS) performs sampling in measurement of the current, causing less measurement accuracy than CC-CV charging.

Moreover, upon charging a battery pack using the charger that supplies a charge current in the sinusoidal current pattern, there is a problem of deterioration in current measurement accuracy due to a current measurement cycle. That is, since the current measurement cycle (for example, 25 ms) of the BMS is three times a charge current cycle (for example, 8.3 ms) of the charger, there is a possibility of continuous mismeasurement of the current. For example, when the current is measured at the peak of the current, the current will be continuously measured only at the peak, and when the current is measured at the trough of the current, the current will be continuously measured only at the trough, thereby causing deterioration in current measurement accuracy.

Moreover, when charging a battery pack using the charger that supplies a charge current in the sinusoidal current pattern, there is a problem of difficulty in ensuring accurate measurement of the charge current due to different frequencies of AC by country.

This section provides background information related to the present invention which is not necessarily prior art.

JP 2018 033257 A relates to system for charging a battery with a pulsating current, wherein a current sensor is included to sample the current and to calculate its effective value. JP 4 344715 B2 discloses a protection relay wherein the frequency of the power system is detected and the sampling frequency is adapted according to the detected frequency.

### SUMMARY

Aspects of the present invention include a battery pack, a method of measuring a charge current of the same, and a charge current measurement system, which enable accurate measurement of a sinusoidal waveform charge current using a charger adapted to charge a battery pack with the sinusoidal waveform charge current.

The above and other aspects and features of the present invention will be described in or will be apparent from the following description of embodiments of the present invention.

In accordance with one aspect of the present invention, under the assumption that a frequency of a sinusoidal waveform charge current is a first frequency, a battery pack can accurately recognize the frequency of the sinusoidal waveform charge current based on a charge current value measured a first number of sampling times for one cycle set to the first frequency.

According to the present invention, it is possible to achieve accurate measurement of a sinusoidal waveform charge current using a charger adapted to charge a battery pack with a sinusoidal waveform charge current.

According to the present invention, it is possible to improve performance of a BMS (fuel gauge, protection, and the like) through accurate measurement of a sinusoidal waveform charge current regardless of frequency.

However, aspects and features of the present invention are not limited to those described above and other aspects and features not mentioned will be clearly understood by a person skilled in the art from the detailed description given below.

The invention is set out in the claims.

### BRIEF DESCRIPTION OF DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is a block diagram of a charge current measurement system according to an embodiment of the present invention;
FIG. 2 is a circuit diagram of a battery pack of the charge current measurement system according to the embodiment of the present invention;
FIGS. 3A and 3B are graphs illustrating examples of a method of recognizing a charge current frequency according to the present invention;
FIG. 4 is a flowchart illustrating a method of measuring a charge current of a battery pack according to an embodiment of the present invention;
FIG. 5 is a graph of an experimental result in measurement of charge current at a current frequency of 100 Hz; and
FIG. 6 is a graph of an experimental result in measurement of charge current at a current frequency of 120 Hz.

### DETAILED DESCRIPTION

Hereinafter, embodiments of the present disclosure will be described, in detail, with reference to the accompanying drawings.

The embodiments described in this specification and the configurations shown in the drawings are only some of the embodiments of the present disclosure and do not represent all of the technical ideas, aspects, and features of the present disclosure. Accordingly, it should be understood that there may be various modifications that can modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

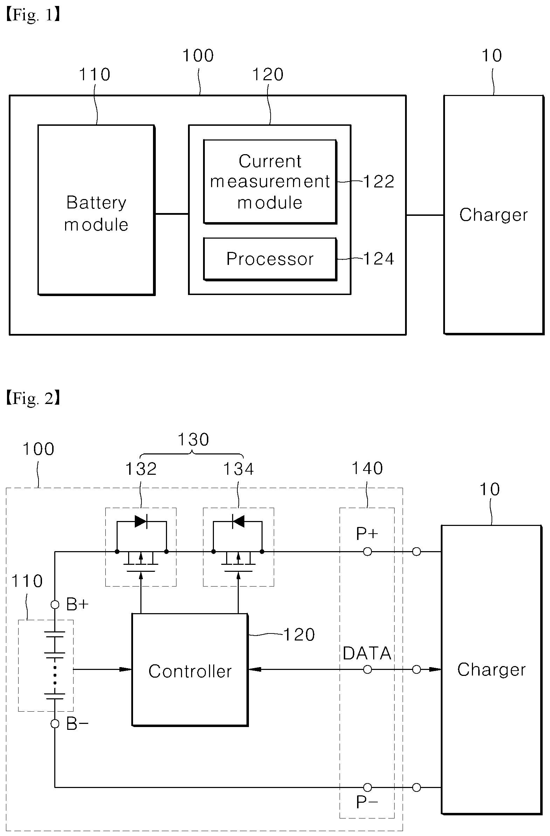

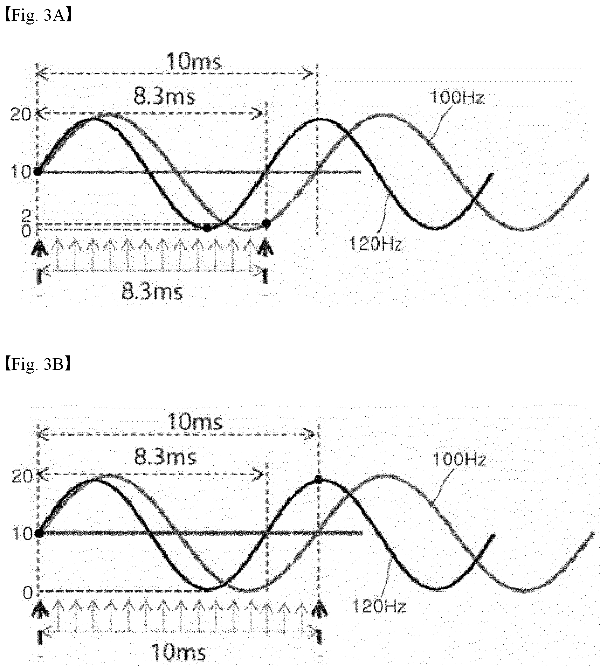

FIG. 1 is a block diagram of a charge current measurement system according to an embodiment of the present invention; FIG. 2 is a circuit diagram of a battery pack of the charge current measurement system according to the embodiment of the present invention; and FIGS. 3A and 3B are graphs illustrating examples of a method of recognizing a charge current frequency according to the present invention.

Referring to FIG. 1 and FIG. 2, a charge current measurement system according to an embodiment of the present invention includes a charger 10 and a battery pack 100.

The charger 10 may supply a sinusoidal waveform charge current to the battery pack 100.

The charger 10 may transmit a predetermined communication signal (for example, a charger connection signal) to the battery pack 100 (for example, to a controller 120) while detecting that the charger 10 is connected to the battery pack 100, and may allow the battery pack 100 (for example, the controller 120) to detect that the battery pack 100 is connected to the charger 10. For example, the charger 10 may transmit the communication signal at predetermined intervals while being connected to the battery pack 100.

The charger 10 may change a frequency of a charge current according to an AC input frequency. The frequency of the charge current may be twice the frequency of the AC input. For example, in Korea, since AC 60 Hz is used, the frequency of the charge current may be 120 Hz, and in the US, since AC 50 Hz is used, the frequency of the charge current may be 100 Hz.

Such a charger 10 may include, for example, an SC-48 charger. "SC-48" refers to a 48 volt sealed charger, as may be well-known to one of ordinary skill in the art.

The battery pack 100 may be connected to the charger 10 through a connector 140 to perform a charging operation of at least one battery module 110. Further, the battery pack 100 may be connected to an external load (not shown) through the connector 140 to perform discharge operation of the battery module 110. A high current path between the battery module 110 and the connector 140 may be used as a charge/discharge path. Power terminals of the charger 10 or the external load (not shown) may be connected to a first pack terminal P+ and a second pack terminal P- of the connector 140.

According to one embodiment, the battery pack 100 and the charger 10 may include signal lines that can send and receive power and communication signals between the battery pack 100 and the charger 10. For example, a communication part (not shown) of the charger 10 may be connected to a communication terminal DATA of the connector 140.

The battery pack 100 may include at least one battery module 110, a controller 120, and a protective circuit 130. In various embodiments, the battery pack 100 may further include other components.

The battery module 110 may include a plurality of battery cells and a module housing. The battery module 110 may include a plurality of battery cells connected to each other in series or in parallel. The battery modules 110 may be connected to each other in series or in parallel.

The battery cells may be received in a stacked state within the module housing. Each of the battery cells may have a cathode lead and an anode lead. The battery cells may be round, prismatic, or pouch type battery cells depending on the shape of the battery.

In the battery pack 100, a single stack of battery cells may form a single module instead of the battery module 110. The cell stack may be received in an accommodation space of a pack housing or in an accommodation space partitioned by a frame, a partition wall, or the like.

The battery cell generates a large amount of heat during charging and discharging. The heat may accumulate in the battery cells and promote degradation of the battery cells. Thus, the battery pack 100 may further include a cooling member to suppress degradation of the battery cells. The cooling member may be disposed at a lower part of the accommodation space which receives the battery cells. Alternatively, the cooling member may be also disposed at an upper portion thereof or on a side surface thereof according to the battery pack 100.

Exhaust gas generated within the battery cell due to abnormal operating conditions, also known as thermal runaway or thermal events of the battery cell, may be discharged outside the battery cell. The battery pack 100 or the battery module 110 may be provided with an exhaust vent or the like to discharge the exhaust gas in order to prevent the exhaust gas from damaging the battery pack 100 or the battery module 110.

The protective circuit 130 may include a charge element 132 and a discharge element 134.

The controller 120 may control charge/discharge of the battery module 110 by detecting voltage of the battery module 110 and controlling operation of the charge element 132 and the discharge element 134. For example, when the battery pack 100 is connected to the charger 10 through the connector 140, the controller 120 may set the charge element 132 to an ON state and the discharge element 134 to an OFF state to allow the battery module 110 to be charged. In addition, when the battery pack 100 is connected to an external system (not shown) through the connector 140, the controller 120 may set the charge element 132 to an OFF state and the discharge element 134 to an ON state to allow the battery module 110 to be discharged.

The charge element 132 and the discharge element 134 may be connected to the high current path between the battery module 110 and the connector 140 and may perform charging or discharging of the battery module 110. The charge element 132 may include a field effect transistor FET 1 and a parasitic diode D1. The discharge element 134 may include a field effect transistor FET 2 and a parasitic diode D2. A connection direction between a source and a drain of FET 1 may be set in an opposite direction to that of FET 2. In this configuration, FET 1 may limit current flow from the connector 140 to the battery module 110. FET 2 may be connected to limit current flow from the battery module 110 to the connector 140. D1 and D2 may be configured to allow electric current to flow in an opposite direction to a direction in which the electric current is limited.

The connector 140 is connected to the battery module 110 and may be connected to the charger 10 to operate as a terminal for charging the battery module 110 upon charging. The connector 140 may be connected to an external load (not shown) to operate as a terminal for discharging the battery module 110 upon discharging. To this end, the connector 140 may include the first pack terminal P+ and the second pack terminal P-. The first pack terminal P+ may be a cathode pack terminal connected to a cathode B+ of the battery module 110. The second pack terminal P- may be an anode pack terminal connected to an anode B- of the battery module 110. When the charger 10 is connected to the connector 140, the charger 10 may charge the battery module 110, and when the external load is connected to the connector 140, discharging from the battery module 110 to the external load may be performed.

The connector 140 may include the communication terminal DATA connected to the controller 120. According to one embodiment, when the charger 10 is connected to the connector 140, the communication terminal DATA may enable communication between the controller 120 and the charger 10.

The controller 120 may include a current measurement module 122 and a processor 124. The controller 120 may be included in a battery management system (BMS).

The current measurement module 122 may measure a charge current supplied from the charger 10 to the battery module 110 under control of the processor 124. The current measurement module 122 may include, for example, a current sensor and the like.

The battery pack 100 according to the embodiment of the invention may further include a shunt resistor (not shown) connected to the high current path between the battery module 110 and the connector 140. For example, the shunt resistor may be connected between the anode B- of the battery module 110 and the second pack terminal P-. Further, the shunt resistor may be connected to the controller 120. Accordingly, the charge current flowing between the battery module 110 and the charger 10 flows through the shunt resistor and the current measurement module 122 may measure the charge current flowing between the entire battery module 110 and the charger 10 from voltage drop caused by the shunt resistor.

Upon detecting connection of the charger 10 to the battery pack, the processor 124 may set a frequency of a sinusoidal waveform charge current supplied from the charger 10 to the battery module 110 to a first frequency, may recognize the frequency of the charge current based on a charge current value measured through the current measurement module 122 according to a first number of sampling times for one cycle set to the first frequency, and may adjust the number of sampling times for one cycle based on the recognized frequency of the charge current. Here, the processor 124 may determine whether the frequency of the charge current is the first frequency or a second frequency based on the charge current value measured (sampled) for the one cycle. Here, the first frequency may be one of 100 Hz and 120 Hz, and the second frequency may be a frequency other than the first frequency selected from among 100 Hz and 120 Hz. In the following embodiments, the first frequency and the second frequency are described as 120 Hz and 100 Hz. However, it should be understood that the first frequency and the second frequency can be realized as various frequencies other than 120 Hz and 100 Hz. For ease of description, the first frequency will be described as 120 Hz and the second frequency will be described as 100 Hz.

Hereinafter, operation of the processor 124 will be described in detail.

The processor 124 may set and store, in a memory, the number of sampling times to be measured for one cycle depending upon the frequency of the sinusoidal waveform charge current supplied from the charger 10 to the battery module 110. In other words, the processor 124 may preset the number of sampling times to be measured for the one cycle in consideration of a measurement time of the charge current value of a battery management device upon application of a charge current of 100 Hz and 120 Hz.

For example, if a single charge current measurement time is set to 0.63 ms, a charge current waveform of 100 Hz can be sampled 17 times for 1 cycle (10 ms) and a charge current waveform of 120 Hz can be sampled 14 times for 1 cycle (8.3 ms). Accordingly, the processor 124 may set the number of sampling times to 17 for one cycle (10 ms) for 100 Hz and to 14 for one cycle (8.3 ms) for 120 Hz. Here, the 17^{th} or 14^{th} charge current value measured (sampled) last may be the first charge current value first measured (sampled) in the next cycle.

Then, when connection of the charger 10 to the battery pack is detected, the processor 124 may assume (set) the frequency of the sinusoidal waveform charge current supplied from the charger 10 to the battery module 110 as the first frequency (for example, 120 Hz). Here, when the charger 10 is supported to communicate with the controller 120, the processor 124 may detect that the charger 10 is connected to the battery pack upon detecting a charger interlock or upon receiving a charger connection signal from the charger 10. The processor 124 may detect connection of the charger 10 by receiving a signal from the communication part (not shown) of the charger 10. For example, the processor 124 may detect connection of the charger 10 based on a predetermined signal transmitted from the communication part of the charger 10.

The charger 10 may not be supported to communicate with the controller 120. In this case, when a sinusoidal waveform charge current supplied from the charger 10 to the battery module 110 is first detected, the processor 124 may assume (set) the frequency of the sinusoidal waveform charge current as the first frequency (for example, 120 Hz).

When the frequency of the sinusoidal waveform charge current is set to the first frequency (for example, 120 Hz), the processor 124 may sample (measure) the charge current value through the current measurement module 122 according to a first number of sampling times for one cycle set to the first frequency.

For example, the processor 124 may sample a charge current waveform of 120 Hz 14 times for 8.3 ms.

When the charge current value is sampled (measured) the first number of sampling times for one cycle set to the first frequency, the processor 124 may recognize the frequency of the charge current based on a difference between the first measured charge current value and the last measured charge current value among charge current values sampled (measured) for the one cycle. Here, the first measured charge current value may be a charge current value measured first among the charge current values measured for the one cycle, and the last measured charge current value may be a charge current value measured last among the charge current values measured for the one cycle. The last measured charge current value may be the first measured charge current value of the next cycle. For example, when a charge current waveform of 120 Hz is sampled (measured) 14 times for one cycle, the 14^{th} measured charge current value may be the first measured charge current value of the next cycle.

Since the charge current has a sinusoidal waveform, the first measured charge current value and the last measured charge current value may be the same or similar values when the charge current is sampled (measured) for exactly one cycle. Thus, the difference between the first measured charge current value and the last measured charge current value may be a value close to zero.

Accordingly, the processor 124 may determine whether the difference between the first measured charge current value and the last measured charge current value is greater than or equal to a preset threshold value, and may recognize the frequency of the charge current to be the first frequency or the second frequency based on a determination result. Here, the difference between the first measured charge current value and the last measured charge current value may be an absolute value and the threshold value may be an arbitrary value, for example, 1 A.

When the difference between the first measured charge current value and the last measured charge current value is less than the threshold value, the processor 124 may determine that the frequency of the charge current is the first frequency.

When the difference between the first measured charge current value and the last measured charge current value is greater than or equal to the threshold value, the processor 124 may determine whether this difference (that is, the difference between the first measured charge current value and the last measured charge current value being greater than or equal to the threshold value) has been continuously detected a preset number of times or more.

In other words, since errors can occur in sampling (measurement) of the charge current, the processor 124 does not need to eliminate such errors. Accordingly, the processor 124 may determine whether the difference between the first measured charge current value and the last measured charge current value is greater than or equal to the threshold value and whether this difference greater than or equal to the threshold value has been continuously detected a certain number of times. Here, the certain number of times may be a preset value, for example, 3 times, 4 times, 10 times, or the like.

If the difference between the first measured charge current value and the last measured charge current value is greater than or equal to the threshold value and this has been continuously detected the certain number of times or more, the processor 124 may determine that the frequency of the charge current is the second frequency rather than the first frequency. Upon determining that the frequency of the charge current is the second frequency, the processor 124 may adjust the number of sampling times for one cycle to a second number of sampling times set to the second frequency.

For example, when the number of sampling times is set to 17 for 1 cycle (10 ms) for 100 Hz and to 14 for 1 cycle (8.3 ms) for 120 Hz, a method of adjusting the number of sampling times according to the frequency of the charge current will be described with reference to FIGS. 3A and 3B.

Referring to FIG. 3A, when a charge current waveform of 100 Hz is sampled 14 times for 8.3 ms under the assumption that the frequency of the charge current is 120 Hz, a difference between the first measured charge current value (10 A) and the 14^{th} measured charge current value (2 A) may be 8 A. In this case, since the difference (8A) between the two charge current values is greater than the threshold value (1A), the processor 124 may determine that the frequency of the charge current is 100 Hz rather than 120 Hz. Then, the processor 124 may sample the charge current waveform 17 times for one cycle (10 ms). When the charge current waveform of 100 Hz is measured (sampled) 17 times for 10 ms, a difference between the first measured charge current value (10 A) and the 14^{th} measured charge current value (10 A) may be 0 A. In this case, since the difference (0A) between the two charge current values is less than the threshold value (1A), it can be confirmed that the frequency of the charge current is 100Hz.

Referring to FIG. 3B, when a charge current waveform of 120 Hz is sampled (measured) 17 times for 10 ms under the assumption that the frequency of the charge current is 100 Hz, a difference between the first measured charge current value (10 A) and the 17^{th} measured charge current value (20 A) may be 10A. In this case, since the difference (10A) between the two charge current values is greater than the threshold value (1A), the processor 124 may determine that the frequency of the charge current is 120Hz rather than 100 Hz. Then, the processor 124 may sample (measure) the charge current waveform 14 times for one cycle (8.3 ms). When the charge current waveform of 120 Hz is sampled (measured) 14 times for 8.3 ms, the difference between the first measured charge current value (10 A) and the 14^{th} measured charge current (10 A) may be 0A. In this case, since the difference (0A) between the two charge current values is less than the threshold value (1A), it can be confirmed that the frequency of the charge current is 120Hz.

Thereafter, the processor 124 may calculate an average of the charge current values measured for the one cycle through the current measurement module 122 according to the adjusted number of sampling times, and may determine the average as the charge current of the battery module 110.

Here, the processor 124 may be realized as a central processing unit (CPU) or a system-on-chip (SoC), may execute an operating system or application to control a plurality of hardware and/or software components connected to the processor 124, and may perform various data processing and computations. The processor 124 may be configured to execute at least one instruction stored in a memory (not shown) and to store result data of execution in the memory.

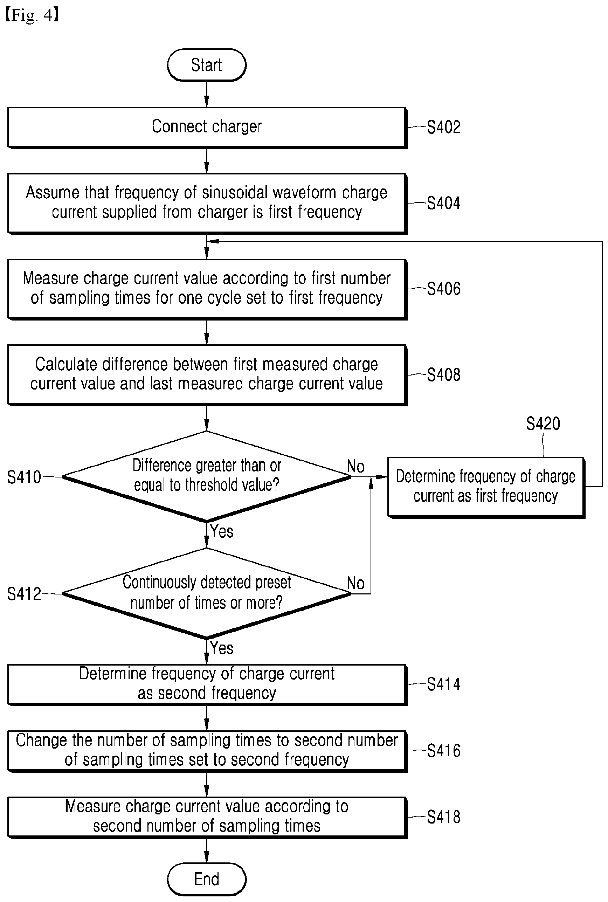

FIG. 4 is flowchart illustrating a method of measuring a charge current of a battery pack according to an embodiment of the present invention.

Referring to FIG. 4, when the charger 10 is connected to the battery pack (S402), the processor 124 assumes that the frequency of a sinusoidal waveform charge current supplied from the charger 10 to the battery pack is a first frequency (for example, 120 Hz) (S404). Here, the charger 10 may be supported or may not be supported to communicate with the controller 120. When the charger 10 is supported to communicate with the controller 120, the processor 124 may recognize that the charger 10 is connected to the battery pack upon detecting a charger interlock or upon receiving a charger connection signal from the charger 10. When the charger 10 is not supported to communicate with the controller 120, the processor 124 may recognize that the charger 10 is connected to the battery pack and may assume (set) the frequency of the sinusoidal waveform charge current as the first frequency (120 Hz), upon first detecting the sinusoidal waveform charge current supplied from the charger 10 to the battery module 110.

After step S404, the processor 124 measures (samples) the charge current value through the current measurement module 122 according to a first number of sampling times for one cycle set to the first frequency (S406). That is, the processor 124 may measure (sample) the charge current value the first number of sampling times set to the first frequency for one cycle of the sinusoidal waveform.

For example, if the number of sampling times is set to 14 for one cycle (8.3 ms) for 120 Hz, the processor 124 may sample (measure) the charge current waveform of 120 Hz 13 times for 8.3 ms.

After step S406, the processor 124 calculates a difference between the first measured charge current value and the last measured charge current value among charge current values sampled (measured) for the one cycle (S408), and determines whether the calculated difference is greater than or equal to a threshold value (S410). Here, the difference between the first measured charge current value and the last measured charge current value may be an absolute value.

Upon determining in step S410 that the difference between the first measured charge current value and the last measured charge current value is greater than or equal to the threshold value, the processor 124 determines whether this difference (that is, the difference between the two measured charge current values is greater than or equal to the threshold value) has been continuously detected a preset number of times or more (S412). Here, the processor 124 may determine whether the difference between the first measured charge current value and the last measured charge current value is greater than or equal to the threshold value and whether this difference has been continuously detected a preset number of times or more, in order to eliminate errors that can occur upon sampling (measurement) of the charge current.

Upon determining in step S412 that the difference between the two measured charge current values is greater than or equal to the threshold value and that this difference has been detected a certain number of times, the processor 124 determines that the frequency of the charge current is a second frequency (S414) and changes the number of sampling times to a second number of sampling times set to the second frequency (S416).

After step S416, the processor 124 measures the charge current values through the current measurement module 122 according to the second number of sampling times (S420). Thereafter, the processor 124 may calculate an average of the charge current values measured for the one cycle according to the second number of sampling times, and may determine the average as the charge current of the battery module 110.

Upon determining in step S412 that the difference between the two measured charge current values is greater than or equal to the threshold value but that this difference has not been continuously detected a certain number of times, the processor 124 determines that the frequency of the charge current is the first frequency (S420), and performs step S406.

Upon determining in step S410 that the difference between the first measured charge current value and the last measured charge current value is not greater than the threshold value, the processor 124 determines that the frequency of the charge current is the first frequency (S420), and performs step S406. That is, when the frequency of the charge current is the first frequency, the processor 124 may continue to measure (sample) the charge current values according to the first number of sampling times.

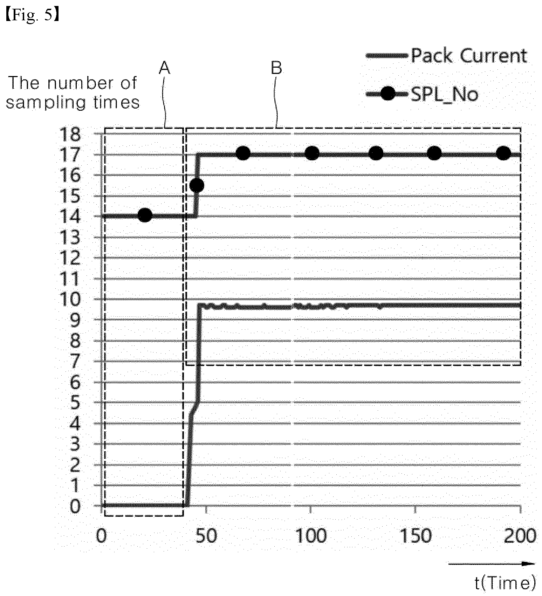

FIG. 5 is a graph showing an experimental result in measurement of charge current at a current frequency of 100 Hz.

FIG. 5 shows an experimental result in measurement of charge current values under conditions that 100V/50Hz is applied to the charger 10 and the frequency of a charge current is set to 100 Hz. Referring to FIG. 5, the processor 124 samples the charge current value 14 times for one cycle under the assumption that the frequency of the charge current in an initial region A is 120 Hz. Then, when the frequency of the charge current is recognized to be 100 Hz rather than 120 Hz, the processor 124 may change the number of sampling times to 17. Next, when the charge current value is sampled 17 times for one cycle as in Region B, it can be confirmed that the charge current remains constant. Here, the amplitude of the charge current may be about 100 mA.

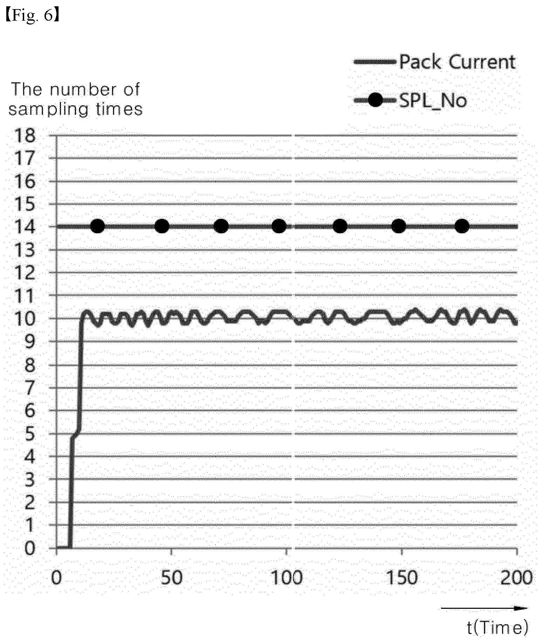

FIG. 6 is a graph showing an experimental result in measurement of charge current at a current frequency of 120 Hz.

FIG. 6 shows an experimental result in measurement of charge current values under conditions that 110V/60Hz is applied to the charger 10 and the frequency of a charge current is set to 120 Hz. Referring to FIG. 6, the processor 124 samples the charge current value 14 times for one cycle under the assumption that the frequency of the charge current is 120 Hz. Then, when the frequency of the charge current is recognized to be 120 Hz, the processor 124 may sample the charge current value 14 times for one cycle. By sampling the charge current value 14 times for one cycle, it can be confirmed that the charge current remains relatively constant. Here, the amplitude of the charge current may be about 500 mA.

As described above, according to the present invention, it is possible to achieve accurate measurement of a sinusoidal waveform charge current using a charger adapted to charge a battery pack with the sinusoidal waveform charge current.

According to the present invention, it is possible to improve performance of a BMS (fuel gauge, protection, etc.) through accurate measurement of a sinusoidal waveform charge current regardless of frequency.

The embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present invention has been described with reference to embodiments and drawings illustrating aspects thereof, the present invention is not limited thereto. Various modifications and variations can be made by a person skilled in the art to which the present invention belongs within the scope of the claims.

## Claims

1. A battery pack (100) comprising:
a battery module (110) comprising a plurality of battery cells;
a current measurement module (122) configured to measure a charge current supplied to the battery module; and
a processor (124),
wherein, upon detecting connection of a charger to the battery pack, the processor is configured to: set a frequency of a sinusoidal waveform charge current supplied from the charger to the battery module to a first frequency; recognize the frequency of the charge current based on a charge current value measured through a current measurement module according to a first number of sampling times for one cycle set to the first frequency; and adjust the number of sampling times for one cycle based on the recognized frequency of the charge current.

2. The battery pack according to claim 1, wherein the processor is configured to detect that the charger is connected to the battery pack, upon detecting a charger interlock or upon receiving a charger connection signal from the charger.

3. The battery pack according to claim 1 or 2, wherein the processor is configured to recognize the frequency of the charge current based on a difference between the first measured charge current value and the last measured charge current value among charge current values measured for the one cycle.

4. The battery pack according to claim 3, wherein the processor is configured to determine that the frequency of the charge current is the first frequency when the difference between the first measured charge current value and the last measured charge current value is less than a preset threshold, and determine that the frequency of the charge current is a second frequency when the difference between the first measured charge current value and the last measured charge current value is greater than or equal to the preset threshold, and wherein said difference greater than or equal to the preset threshold is detected a preset number of times or more.

5. The battery pack according to claim 4, wherein the processor is configured to adjust the number of sampling times for one cycle to a second number of sampling times set to the second frequency, upon determining that the frequency of the charge current is the second frequency.

6. The battery pack according to any preceding claim, wherein the processor is configured to calculate an average of the charge current values measured for the one cycle through the current measurement module according to the adjusted number of sampling times, and to determine the average as the charge current of the battery module.

7. A method of measuring a charge current of a battery pack (100) including a battery module (110), a current measurement module (122), and a processor (124), the method comprising, upon detecting connection of a charger to the battery pack:
setting, by the processor, a frequency of a sinusoidal waveform charge current supplied from the charger to the battery module to a first frequency;
recognizing, by the processor, the frequency of the charge current based on a charge current value measured through a current measurement module according to a first number of sampling times for one cycle set to the first frequency; and
adjusting, by the processor, the number of sampling times for one cycle based on the recognized frequency of the charge current.

8. The method according to claim 7, wherein, in the step of setting to the first frequency, the processor detects that the charger is connected to the battery pack, upon detecting a charger interlock or upon receiving a charger connection signal from the charger.

9. The method according to claim 7 or 8, wherein, in the step of recognizing the frequency of the charge current, the processor recognizes the frequency of the charge current based on a difference between the first measured charge current value and the last measured charge current value among charge current values measured for the one cycle.

10. The method according to claim 9, wherein, in the step of recognizing the frequency of the charge current,
the processor determines that the frequency of the charge current is the first frequency when the difference between the first measured charge current value and the last measured charge current value is less than a preset threshold, and determines that the frequency of the charge current is a second frequency when the difference between the first measured charge current value and the last measured charge current value is greater than or equal to the preset threshold, and wherein said difference greater than or equal to the preset threshold is detected a preset number of times or more.

11. The method according to claim 10, wherein, in the step of adjusting the number of sampling times for one cycle, the processor adjusts the number of sampling times for one cycle to a second number of sampling times set to the second frequency, upon determining that the frequency of the charge current is the second frequency.

12. The method according to any one of claims 7 to 11, further comprising,
after the step of adjusting the number of sampling times for one cycle,calculating, by the processor, an average of the charge current values measured for the one cycle through the current measurement module according to the adjusted number of sampling times, followed by determining the average as the charge current of the battery module.

13. A charge current measurement system comprising:
a battery pack (100) comprising a battery module (110), a current measurement device (122), and a processor (124); and
a charger (10) adapted to supply a sinusoidal waveform charge current to the battery module when connection of the charger to the battery pack is detected,
wherein the processor is configured to set a frequency of a sinusoidal waveform charge current supplied from the charger to the battery module to a first frequency, recognize the frequency of the charge current based on a charge current value measured through a current measurement module according to a first number of sampling times for one cycle set to the first frequency, and adjust the number of sampling times for one cycle based on the recognized frequency of the charge current.

14. The charge current measurement system according to claim 13, wherein the processor is configured to recognize the frequency of the charge current based on a difference between the first measured charge current value and the last measured charge current value among charge current values measured for the one cycle.

15. The charge current measurement system according to claim 14, wherein the processor is configured to determine that the frequency of the charge current is the first frequency when the difference between the first measured charge current value and the last measured charge current value is less than a preset threshold, and determine that the frequency of the charge current is a second frequency when the difference between the first measured charge current value and the last measured charge current value is greater than or equal to the preset threshold, and wherein said difference greater than or equal to the preset threshold is detected a preset number of times or more.

## Patentansprüche

1. Batteriepack (100), umfassend:
ein Batteriemodul (110), das eine Vielzahl von Batteriezellen umfasst;
ein Strommessmodul (122), das konfiguriert ist, einen dem Batteriemodul zugeführten Ladestrom zu messen; und
einen Prozessor (124),
wobei der Prozessor bei Detektieren einer Verbindung eines Ladegeräts mit dem Batteriepack konfiguriert ist zum:
Einstellen einer Frequenz eines vom Ladegerät an das Batteriemodul zugeführten sinusförmigen Ladestroms auf eine erste Frequenz; Erkennen der Frequenz des Ladestroms basierend auf einem mit einem Strommessmodul gemessenen Ladestromwerts gemäß einer ersten Anzahl von Abtastzeiten für einen Zyklus, die auf die erste Frequenz eingestellt ist, und Anpassen der Anzahl von Abtastzeiten für einen Zyklus basierend auf der erkannten Frequenz des Ladestroms.

2. Batteriepack nach Anspruch 1, wobei der Prozessor konfiguriert ist, zu detektieren, dass das Ladegerät mit dem Batteriepack verbunden ist, indem er eine Ladegerätverriegelung detektiert oder ein Ladegerätverbindungssignal vom Ladegerät empfängt.

3. Batteriepack nach Anspruch 1 oder 2, wobei der Prozessor konfiguriert ist, die Frequenz des Ladestroms basierend auf einer Differenz zwischen dem ersten gemessenen Ladestromwert und dem letzten gemessenen Ladestromwert unter für einen Zyklus gemessenen Ladestromwerten zu erkennen.

4. Batteriepack nach Anspruch 3, wobei der Prozessor konfiguriert ist, zu bestimmen, dass die Frequenz des Ladestroms die erste Frequenz ist, wenn die Differenz zwischen dem ersten gemessenen Ladestromwert und dem letzten gemessenen Ladestromwert kleiner als ein voreingestellter Schwellenwert ist, und zu bestimmen, dass die Frequenz des Ladestroms eine zweite Frequenz ist, wenn die Differenz zwischen dem ersten gemessenen Ladestromwert und dem letzten gemessenen Ladestromwert größer oder gleich dem voreingestellten Schwellenwert ist, und wobei diese Differenz, die größer oder gleich dem voreingestellten Schwellenwert ist, eine voreingestellte Anzahl von Malen oder öfter detektiert wird.

5. Batteriepack nach Anspruch 4, wobei der Prozessor konfiguriert ist, die Anzahl von Abtastzeiten für einen Zyklus auf eine zweite Anzahl von Abtastzeiten anzupassen, die auf die zweite Frequenz eingestellt ist, sobald er bestimmt, dass die Frequenz des Ladestroms die zweite Frequenz ist.

6. Batteriepack nach einem vorstehenden Anspruch, wobei der Prozessor konfiguriert ist, einen Mittelwert der für einen Zyklus durch das Strommessmodul gemessenen Ladestromwerte gemäß der angepassten Anzahl von Abtastzeiten zu berechnen und diesen Mittelwert als Ladestrom des Batteriemoduls zu bestimmen.

7. Verfahren zum Messen des Ladestroms eines Batteriepacks (100), das ein Batteriemodul (110), ein Strommessmodul (122) und einen Prozessor (124) beinhaltet, wobei das Verfahren beim Detektieren einer Verbindung eines Ladegeräts mit dem Batteriepack Folgendes umfasst:
Einstellen, durch den Prozessor, einer Frequenz eines vom Ladegerät an das Batteriemodul zugeführten sinusförmigen Ladestroms auf eine erste Frequenz;
Erkennen, durch den Prozessor, der Frequenz des Ladestroms basierend auf einem Ladestromwert, der mit einem Strommessmodul gemäß einer ersten Anzahl von Abtastzeiten für einen Zyklus, die auf die erste Frequenz eingestellt ist, gemessen wurde; und
Anpassen, durch den Prozessor, der Anzahl von Abtastzeiten für einen Zyklus basierend auf der erkannten Frequenz des Ladestroms.

8. Verfahren nach Anspruch 7, wobei der Prozessor im Schritt des Einstellens der ersten Frequenz detektiert, dass das Ladegerät mit dem Batteriepack verbunden ist, indem er eine Ladegerätverriegelung detektiert oder ein Ladegerätverbindungssignal vom Ladegerät empfängt.

9. Verfahren nach Anspruch 7 oder 8, wobei der Prozessor im Schritt des Erkennens der Frequenz des Ladestroms die Frequenz des Ladestroms basierend auf einer Differenz zwischen dem ersten gemessenen Ladestromwert und dem letzten gemessenen Ladestromwert unter für einen Zyklus gemessenen Ladestromwerten erkennt.

10. Verfahren nach Anspruch 9, wobei im Schritt des Erkennens der Frequenz des Ladestroms,
der Prozessor bestimmt, dass die Frequenz des Ladestroms die erste Frequenz ist, wenn die Differenz zwischen dem ersten gemessenen Ladestromwert und dem letzten gemessenen Ladestromwert kleiner als ein voreingestellter Schwellenwert ist, und bestimmt, dass die Frequenz des Ladestroms eine zweite Frequenz ist, wenn die Differenz zwischen dem ersten gemessenen Ladestromwert und dem letzten gemessenen Ladestromwert größer oder gleich dem voreingestellten Schwellenwert ist, und wobei diese Differenz, die größer oder gleich dem voreingestellten Schwellenwert ist, eine voreingestellte Anzahl von Malen oder öfter detektiert wird.

11. Verfahren nach Anspruch 10, wobei der Prozessor im Schritt des Anpassens der Anzahl von Abtastzeiten für einen Zyklus die Anzahl von Abtastzeiten für einen Zyklus auf eine zweite Anzahl von Abtastzeiten anpasst, die auf die zweite Frequenz eingestellt ist, nachdem er bestimmt hat, dass die Frequenz des Ladestroms die zweite Frequenz ist.

12. Verfahren nach einem der Ansprüche 7 bis 11, weiter umfassend:
nach dem Schritt des Anpassens der Anzahl von Abtastzeiten für einen Zyklus, Berechnen, durch den Prozessor, eines Mittelwerts der für den einen Zyklus über das Strommessmodul gemessenen Ladestromwerte gemäß der angepassten Anzahl von Abtastzeiten, gefolgt von Bestimmen des Mittelwerts als den Ladestrom des Batteriemoduls.

13. Ladestrommesssystem, umfassend:
ein Batteriepack (100), das ein Batteriemodul (110), eine Strommessvorrichtung (122) und einen Prozessor (124) umfasst; und
ein Ladegerät (10), das angepasst ist, dem Batteriemodul einen sinusförmigen Ladestrom zuzuführen, sobald eine Verbindung des Ladegeräts mit dem Batteriepack detektiert wird,
wobei der Prozessor konfiguriert ist, eine Frequenz eines vom Ladegerät an das Batteriemodul zugeführten sinusförmigen Ladestroms auf eine erste Frequenz einzustellen, die Frequenz des Ladestroms basierend auf einem mit einem Strommessmodul gemessenen Ladestromwert gemäß einer ersten Anzahl von Abtastzeiten für einen Zyklus, die auf die erste Frequenz eingestellt ist, zu erkennen und die Anzahl von Abtastzeiten für einen Zyklus basierend auf der erkannten Frequenz des Ladestroms anzupassen.

14. Ladestrommesssystem nach Anspruch 13, wobei der Prozessor konfiguriert ist, die Frequenz des Ladestroms basierend auf einer Differenz zwischen dem ersten gemessenen Ladestromwert und dem letzten gemessenen Ladestromwert unter für einen Zyklus gemessenen Ladestromwerten zu erkennen.

15. Ladestrommesssystem nach Anspruch 14, wobei der Prozessor konfiguriert ist, zu bestimmen, dass die Frequenz des Ladestroms die erste Frequenz ist, wenn die Differenz zwischen dem ersten gemessenen Ladestromwert und dem letzten gemessenen Ladestromwert kleiner als ein voreingestellter Schwellenwert ist, und zu bestimmen, dass die Frequenz des Ladestroms eine zweite Frequenz ist, wenn die Differenz zwischen dem ersten gemessenen Ladestromwert und dem letzten gemessenen Ladestromwert größer oder gleich dem voreingestellten Schwellenwert ist, und wobei diese Differenz, die größer oder gleich dem voreingestellten Schwellenwert ist, eine voreingestellte Anzahl von Malen oder öfter detektiert wird.

## Revendications

1. Bloc-batterie (100) comprenant :
un module de batterie (110) comprenant une pluralité de cellules de batterie ;
un module de mesure de courant (122) configuré pour mesurer un courant de charge fourni au module de batterie ; et
un processeur (124),
dans lequel, lors de la détection de la connexion d'un chargeur au bloc-batterie, le processeur est configuré pour :
définir une fréquence d'un courant de charge de forme d'onde sinusoïdale fourni par le chargeur au module de batterie sur une première fréquence ; reconnaître la fréquence du courant de charge sur la base d'une valeur de courant de charge mesurée par le biais d'un module de mesure de courant selon un premier nombre de périodes d'échantillonnage pour un cycle défini sur la première fréquence ; et ajuster le nombre de périodes d'échantillonnage pour un cycle sur la base de la fréquence reconnue du courant de charge.

2. Bloc-batterie selon la revendication 1, dans lequel le processeur est configuré pour détecter que le chargeur est connecté au bloc-batterie, lors de la détection d'un verrouillage de chargeur ou lors de la réception d'un signal de connexion de chargeur en provenance du chargeur.

3. Bloc-batterie selon la revendication 1 ou 2, dans lequel le processeur est configuré pour reconnaître la fréquence du courant de charge sur la base d'une différence entre la première valeur de courant de charge mesurée et la dernière valeur de courant de charge mesurée parmi des valeurs de courant de charge mesurées pour un cycle.

4. Bloc-batterie selon la revendication 3, dans lequel le processeur est configuré pour déterminer que la fréquence du courant de charge est la première fréquence lorsque la différence entre la première valeur de courant de charge mesurée et la dernière valeur de courant de charge mesurée est inférieure à un seuil prédéfini et pour déterminer que la fréquence du courant de charge est une seconde fréquence lorsque la différence entre la première valeur de courant de charge mesurée et la dernière valeur de courant de charge mesurée est supérieure ou égale au seuil prédéfini et dans lequel ladite différence supérieure ou égale au seuil prédéfini est détectée un nombre prédéfini de fois ou plus.

5. Bloc-batterie selon la revendication 4, dans lequel le processeur est configuré pour ajuster le nombre de périodes d'échantillonnage pour un cycle sur un second nombre de périodes d'échantillonnage définies sur la seconde fréquence, lors de la détermination que la fréquence du courant de charge est la seconde fréquence.

6. Bloc-batterie selon une quelconque revendication précédente, dans lequel le processeur est configuré pour calculer une moyenne des valeurs de courant de charge mesurées pour un cycle à travers le module de mesure de courant selon le nombre ajusté de périodes d'échantillonnage et pour déterminer la moyenne comme courant de charge du module de batterie.

7. Procédé de mesure d'un courant de charge d'un bloc-batterie (100) incluant un module de batterie (110), un module de mesure de courant (122) et un processeur (124), le procédé comprenant, lors de la détection d'une connexion d'un chargeur au bloc-batterie :
le réglage, par le processeur, d'une fréquence d'un courant de charge de forme d'onde sinusoïdale fourni par le chargeur au module de batterie sur une première fréquence ;
la reconnaissance, par le processeur, de la fréquence du courant de charge en fonction d'une valeur de courant de charge mesurée par un module de mesure de courant selon un premier nombre de temps d'échantillonnage pour un cycle défini sur la première fréquence ; et
l'ajustement, par le processeur, du nombre de périodes d'échantillonnage pour un cycle sur la base de la fréquence reconnue du courant de charge.

8. Procédé selon la revendication 7, dans lequel, lors de l'étape de réglage sur la première fréquence, le processeur détecte que le chargeur est connecté au bloc-batterie, lors de la détection d'un verrouillage de chargeur ou lors de la réception d'un signal de connexion de chargeur en provenance du chargeur.

9. Procédé selon la revendication 7 ou 8, dans lequel, lors de l'étape de reconnaissance de la fréquence du courant de charge, le processeur reconnaît la fréquence du courant de charge sur la base d'une différence entre la première valeur de courant de charge mesurée et la dernière valeur de courant de charge mesurée parmi des valeurs de courant de charge mesurées pour un cycle.

10. Procédé selon la revendication 9, dans lequel, lors de l'étape de reconnaissance de la fréquence du courant de charge,
le processeur détermine que la fréquence du courant de charge est la première fréquence lorsque la différence entre la première valeur de courant de charge mesurée et la dernière valeur de courant de charge mesurée est inférieure à un seuil prédéfini et détermine que la fréquence du courant de charge est une seconde fréquence lorsque la différence entre la première valeur de courant de charge mesurée et la dernière valeur de courant de charge mesurée est supérieure ou égale au seuil prédéfini, et dans lequel ladite différence supérieure ou égale au seuil prédéfini est détectée un nombre prédéfini de fois ou plus.

11. Procédé selon la revendication 10, dans lequel, lors de l'étape d'ajustement du nombre de périodes d'échantillonnage pour un cycle, le processeur ajuste le nombre de périodes d'échantillonnage pour un cycle sur un second nombre de périodes d'échantillonnage défini sur la seconde fréquence, lors de la détermination que la fréquence du courant de charge est la seconde fréquence.

12. Procédé selon l'une quelconque des revendications 7 à 11, comprenant en outre,
après l'étape d'ajustement du nombre de périodes d'échantillonnage pour un cycle, le calcul, par le processeur, d'une moyenne des valeurs de courant de charge mesurées pour un cycle à travers le module de mesure de courant selon le nombre ajusté de périodes d'échantillonnage, puis en déterminant la moyenne comme courant de charge du module de batterie.

13. Système de mesure de courant de charge comprenant :
un bloc-batterie (100) comprenant un module de batterie (110), un dispositif de mesure de courant (122) et un processeur (124) ; et
un chargeur (10) adapté pour fournir un courant de charge de forme d'onde sinusoïdale au module de batterie lorsque la connexion du chargeur au bloc-batterie est détectée,
dans lequel le processeur est configuré pour définir une fréquence d'un courant de charge de forme d'onde sinusoïdale fourni par le chargeur au module de batterie à une première fréquence, reconnaître la fréquence du courant de charge sur la base d'une valeur de courant de charge mesurée par un module de mesure de courant selon un premier nombre de périodes d'échantillonnage pour un cycle défini sur la première fréquence et ajuster le nombre de temps d'échantillonnage pour un cycle sur la base de la fréquence reconnue du courant de charge.

14. Système de mesure du courant de charge selon la revendication 13, dans lequel le processeur est configuré pour reconnaître la fréquence du courant de charge sur la base d'une différence entre la première valeur de courant de charge mesurée et la dernière valeur de courant de charge mesurée parmi des valeurs de courant de charge mesurées pour un cycle.

15. Système de mesure du courant de charge selon la revendication 14, dans lequel le processeur est configuré pour déterminer que la fréquence du courant de charge est la première fréquence lorsque la différence entre la première valeur de courant de charge mesurée et la dernière valeur de courant de charge mesurée est inférieure à un seuil prédéfini et pour déterminer que la fréquence du courant de charge est une seconde fréquence lorsque la différence entre la première valeur de courant de charge mesurée et la dernière valeur de courant de charge mesurée est supérieure ou égale au seuil prédéfini, et dans lequel ladite différence supérieure ou égale au seuil prédéfini est détectée un nombre prédéfini de fois ou plus.
